Europäisches Patentamt

European Patent Office

Office européen des brevets

(19)

(11) **EP 0 825 643 A2**

(12) **EUROPEAN PATENT APPLICATION**

(43) Date of publication:
**25.02.1998 Bulletin 1998/09**

(51) Int Cl.$^6$: **H01L 21/66**

(21) Application number: **97401921.8**

(22) Date of filing: **12.08.1997**

(84) Designated Contracting States:
**AT BE CH DE DK ES FI FR GB GR IE IT LI LU MC NL PT SE**
Designated Extension States:
**AL LT LV RO SI**

(30) Priority: **12.08.1996 JP 212901/96**

(71) Applicant: **SONY CORPORATION Tokyo (JP)**

(72) Inventor: **Tatsumi, Takaaki Shinagawa-ku, Tokyo (JP)**

(74) Representative: **Thévenet, Jean-Bruno et al Cabinet Beau de Loménie 158, rue de l'Université 75340 Paris Cédex 07 (FR)**

(54) **Simulation method for predicting properties of manufactured semiconductor devices**

(57)    A simulation method for manufacturing a semiconductor is disclosed. The manufacturing data stating the recorded information concerning the manufacturing conditions for manufacturing a semiconductor is converted into simulator input data. The simulator input data is then entered to a simulator designed for simulating operating characteristics of the semiconductor, for simulating the semiconductor operating characteristics based on the simulator input data.

FIG.1

## Description

## BACKGROUND OF THE INVENTION

### Field of the Invention

This invention relates to a simulation method for predicting operating characteristics of a semiconductor or semiconductor device. More particularly, it relates to a simulation method which is carried out using manufacturing data stating the recorded information concerning semiconductor manufacturing conditions.

### Description of the Related Art

In the process of development and designing of a semiconductor, tentative or trial manufacturing is usually carried out for predicting and confirming operating characteristics. However, if various parameters such as process parameters defining manufacturing conditions or device parameters defining the shape or size are not set properly in tentative manufacture, such tentative manufacture is unnecessary and meaningless thus wasting the time and cost expended in the tentative manufacture. It is therefore desirable, prior to proceeding to tentative manufacture, to execute simulation using a computer for predicting operating characteristics of the manufactured semiconductor.

Moreover, for those semiconductors whose operating characteristics can be predicted easily by computer simulation, the time and cost for trial manufacture can be curtailed by predicting the operating characteristics by simulation.

In the light of the above, prediction of the operating characteristics by simulation has become crucial in the development and designing of semiconductors.

Meanwhile, in manufacturing semiconductors, manufacture is carried out based on manufacturing data stating the recorded information concerning manufacturing conditions for semiconductors. Therefore, if, in carrying out simulation for semiconductors, manufacturing data entered to a manufacturing device can be used as simulator input data for entry to a simulator designed for simulating the operating characteristics of the semiconductors, the necessity of newly setting simulator input data is eliminated, thus enabling facilitated simulation.

However, if simulation is carried out based on semiconductor manufacturing data, there usually occurs information surplus or deficit, such that simulation cannot be realised if the manufacturing data is used directly. For example, information items such as the temperature rise rate or temperature falling rate in the heating process usually are not contained in the manufacturing data *per se,* such that, if the manufacturing data is directly used for carrying out the simulation, these information items are not available. On the other hand, information which is unnecessary for simulation, such as the name of a device used for manufacture or items to be checked during manufacture, is also included in the manufacturing data, so that the manufacturing data per se cannot be used as simulator input data.

Since the manufacturing data cannot be used as simulator input data, the conventional practice has been for an engineer having suitable knowledge for preparing the simulator input data to extract the necessary information from the manufacturing data and to add such information items not provided by the manufacturing data in order to newly prepare simulator input data.

However, it is not possible for all engineers to prepare new simulator input data by extracting the necessary information from the manufacturing data or to add the information deficit in the manufacturing data; such work can be done solely by an engineer having professional knowledge and experience in preparing the simulator input data.

In addition, since the simulator input data fluctuates depending on operating characteristics desired to be investigated and on the sorts and generations of the semiconductor, a highly advanced knowledge is required for preparing the simulator input data.

Moreover, since no system for supporting preparation of simulator input data has so far been presented to the market, the task of preparing the data is up to the knowledge of engineers.

## SUMMARY OF THE INVENTION

It is therefore an object of the present invention to provide a semiconductor simulation method whereby simulation concerning the operating characteristics can be achieved easily based on semiconductor manufacturing data without requiring particular knowledge or skill.

According to the present invention, there is provided a semiconductor simulation method including a converting step of converting manufacturing data stating the recorded information concerning the manufacturing conditions for manufacturing a semiconductor into simulator input data necessary for simulation of the distribution of impurities in the semiconductor, and a simulating step of entering the simulator input data to a simulator simulating the operating characteristics of the semiconductor for carrying out simulation of impurities and electric characteristics of the semiconductor based on the simulator input data.

The semiconductor simulation method may further include a conversion rule setting step of setting, prior to the conversion step, the conversion rule to be applied at the time of converting the manufacturing data into the simulator input data.

The semiconductor simulation method may further include the steps of previously registering in a database the information necessary for converting the manufacturing data into simulator input data, and, in the conversion step, extracting from the database the information necessary for conversion.

With the semiconductor simulation method according to the present invention, since the manufacturing data is first converted into simulator input data before being entered to a simulator, simulation of the operating characteristics of the semiconductor can be easily achieved using the manufacturing data.

Thus, with the semiconductor simulation method according to the present invention, simulation of the operating characteristics of the semiconductor can be easily achieved, without requiring special knowledge, based on the semiconductor manufacturing data.

Moreover, since the simulator input data is formulated by conversion from the semiconductor manufacturing data, the simulator input data can be formulated in a shorter time than with the conventional method of manually formulating simulator input data each time simulation is performed. The result is a significantly shortened time consumed in semiconductor simulation.

In addition, the simulator input data can be formulated with fewer errors than with the conventional method of manually formulating simulator input data each time simulation is made. The result is semiconductor simulation of improved accuracy.

According to the present invention, since semiconductor simulation can be achieved with improved accuracy and in a shorter time without requiring particular knowledge, semiconductor development and designing can be achieved extremely efficiently. The result is that the cost or time necessary for developing or designing a semiconductor can be reduced significantly.

Further features and advantages of the present invention will become clear from the following description of preferred embodiments thereof, given by way of example, illustrated in the accompanying drawings, in which:

Fig. 1 is a block diagram showing a structural example of a simulation device according to a first embodiment of the present invention.

Fig. 2 is a flowchart showing the flow of a semiconductor simulation method which may be implemented by the device of Fig. 1.

Fig. 3 shows an example of a a main screen first displayed at the time of setting a conversion rule.

Fig. 4 shows an example of an editing screen for editing the conversion rule.

Fig. 5 shows an example of an input screen for information concerning gate oxidation.

Fig. 6 shows an example of a selection screen for the conversion rule and the manufacturing data.

Fig. 7 is a flowchart illustrating the flow at the time of conversion of the manufacturing data into simulator input data.

## DESCRIPTION OF THE PREFERRED EMBODIMENTS

Referring to the drawings, preferred embodiments of the present invention will be explained in detail. It should be noted that the present invention is not limited to the embodiments now explained and may be optionally modified without departing from the scope of the invention.

In the semiconductor simulation method according to the present invention, manufacturing data stating the recorded information concerning semiconductor manufacturing conditions is converted into simulator input data required for simulation of the semiconductor operating characteristics. The simulator input data is entered to a simulator designed for simulating the semiconductor operating characteristics for carrying out simulation of impurities and operating characteristics of the semiconductor based on the simulator input data.

The information contained in the manufacturing data and the information contained in the simulator input data are not necessarily in a one-for-one correspondence with each other. Specifically, from among the manufacturing data concerning the oxidation process, containing the information on, for example, the process number, process name, device name, explanation of processing contents, initial temperature, temperature at the time of oxidation, ultimate temperature, atmosphere, oxidation time, film thickness or film thickness error, the information required for the simulator input data is the initial temperature, temperature during oxidation, ultimate temperature, atmosphere, oxidation time and film thickness, while the remaining information items are not required for simulation. Moreover, the information irrelevant to simulation of impurity distribution in the semiconductor, and hence unneeded as the simulator input data, such as the information on film thickness measurement carried out after oxidation, are occasionally stated among the manufacturing data.

On the other hand, if simulation is carried out on the oxidation process, information on temperature changes per unit time, that is the information on the temperature rising rate or the temperature falling rate, or the queuing time since charging into a furnace until start of the oxidation processing, is also required in addition to data contained in the manufacturing data. However, these information items are dependent on the devices used and the relevant conditions are determined unequivocally once the device used is set, so that the information items are usually not stated as manufacturing data.

In the light of the above, the information contained in the manufacturing data is not necessarily in one-for-one correspondence with the information contained in the simulator input data. Thus, in the present embodiment, the unneeded information among the manufacturing data is omitted, while only the necessary information of the manufacturing data is extracted, whilst the information not contained in the manufacturing data but needed for simulation, if any, is supplemented.

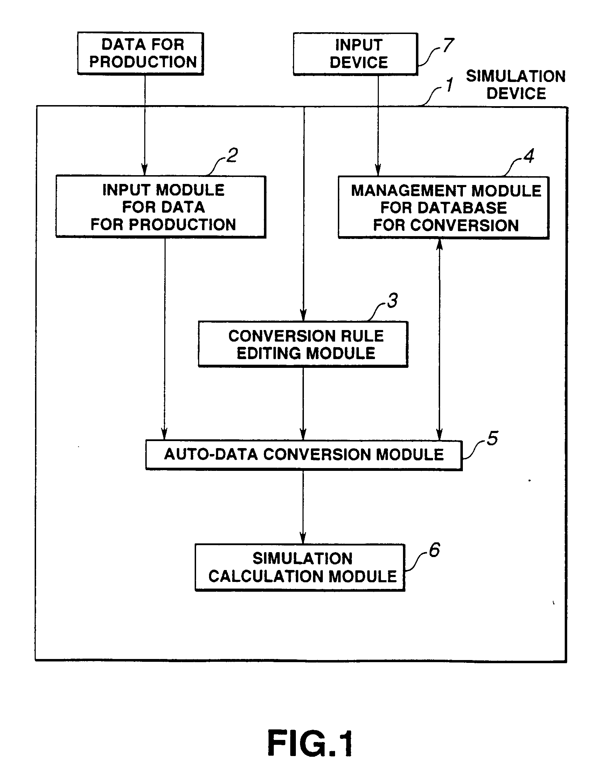

Referring to the block diagram of Fig. 1, the simulation device for converting manufacturing data into simulator input data for carrying out simulation is explained by referring to the block diagram of Fig. 1.

Referring to Fig. 1, the simulation device 1 includes a manufacturing data input module 2, a conversion rule editing module 3, a conversion database management module 4, an automatic data conversion module 5 and a simulation calculating module 6. Meanwhile, these modules are realised on a computer, such as a work station, and are controlled by a central processing unit (CPU) of the computer.

The manufacturing data input module 2 is configured for reading semiconductor manufacturing data into the simulation device 1. The manufacturing data is exchanged as data files on a computer, and is read via a recording medium, such as a floppy disc, into the simulation device 1, or is read over a computer network into the simulation device 1. That is, the manufacturing data input module 2 reads the manufacturing data from the recording medium, such as the floppy disc, for taking in the manufacturing data into the simulation device 1, or receives manufacturing data over a computer network for taking in the manufacturing data into the simulation device 1.

The conversion rule editing module 3 sets conversion rules prescribing how the manufacturing data is to be converted into the simulator input data. The information required for setting the conversion rule is entered from an input device 7, such as a keyboard, by the user. The conversion rule editing module 3 also controls the graphical user interface for enabling the user to enter the information on the conversion rule easily.

The conversion database management module 4 registers the information not stated in the manufacturing data but required for executing the simulation, such as the information dependent on the semiconductor manufacturing device, in a database. The information not stated in the manufacturing data but required for executing the simulation is entered by the user via input device 7, such as a keyboard. The conversion database management module 4 also controls the graphical user interface for enabling the user to enter these information items readily.

By having the information not stated in the manufacturing data but required for executing the simulation registered in the database, it becomes unnecessary to add or enter the information every time the manufacturing data is converted into the simulator input data, thus facilitating conversion.

The automatic data conversion module 5 converts manufacturing data entered from the manufacturing data input module 2 into the simulator input data in accordance with the conversion rule as set by the conversion rule editing module 3. That is, the automatic data conversion module 5 extracts the necessary information from the manufacturing data and adds the missing information for preparing the simulator input data. If necessary, the information registered in the database by the conversion database management module 4 is extracted for addition to the simulator input data. The simulator input data, prepared by conversion of the manufacturing data, is entered from the automatic data conversion module 5 into the simulation calculating module 6.

The simulation calculating module 6 solves a physical equation concerning semiconductor physics, based on the simulator input data entered from the automatic data conversion module 5, for calculating the semiconductor operating characteristics. That is, the simulation calculating module 6 operates as a simulator for calculating the operating characteristics of the semiconductor.

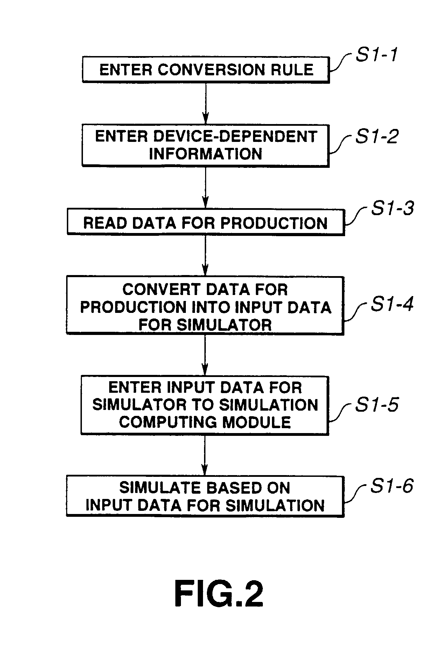

In connection with the semiconductor simulation method embodying the present invention, carried out by the above-described simulation device 1, the overall flow of the simulation is explained by referring to a flowchart of Fig.2.

In executing the semiconductor simulation, the information on the conversion rule governing the conversion of the manufacturing data into the simulator input data is entered at step S1-1 by the input device 7, such as a keyboard, to the simulation device. At this time, the conversion rule editing module 3 controls the graphical user interface for enabling the user to easily enter the information on the conversion rule, while setting the conversion rule for converting the manufacturing data into simulator input data based on the input from the input device 7, such as a keyboard.

The information on the conversion rule may, for example, be a keyword for detecting the portion of the manufacturing data which is to be converted, which information contained in the manufacturing data is to be extracted, how the information not supplied by the manufacturing data is to be supplemented, by which form the converted data is to be outputted, and so forth.

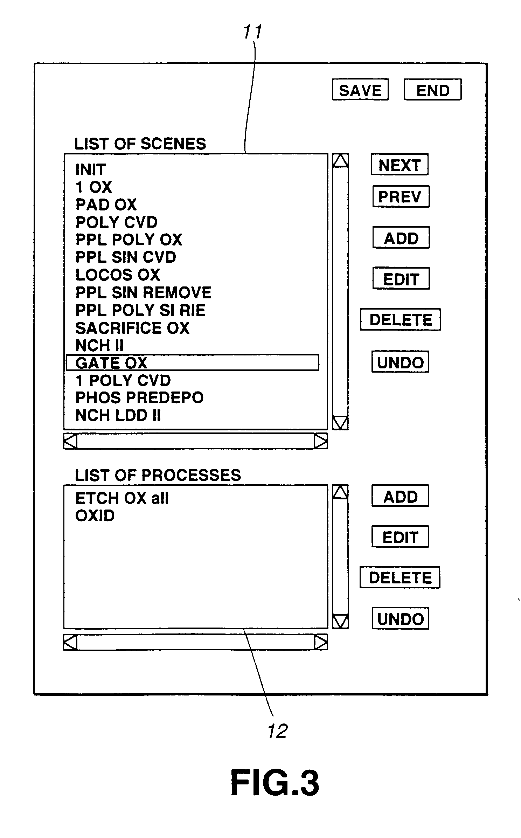

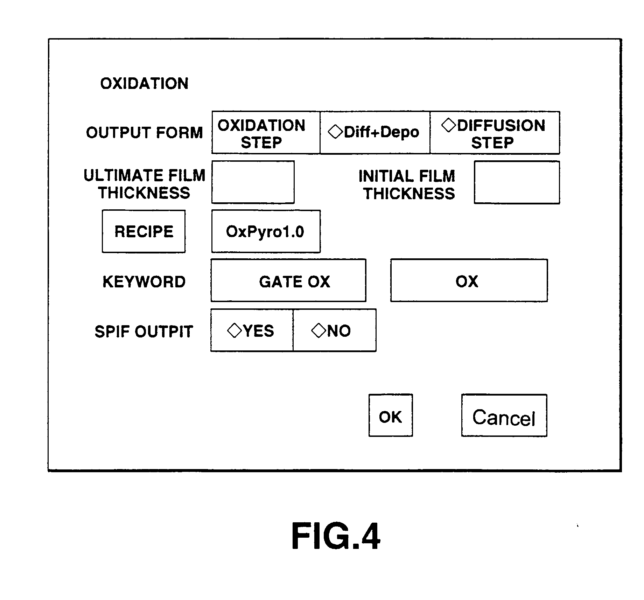

Figs.3 and 4 show an example of a screen displayed by the conversion rule editing module 3 during setting of the conversion rule.

Fig.3 shows a main screen displayed first when setting the conversion rule. In this main screen, a first window 11 and a second window 12 are delineated on upper and lower portions of the main screen, respectively, as shown in Fig.

3. In the first window 11 is displayed the flow of semiconductor manufacture. In the second window 12 is set by which process steps in impurity simulation the manufacturing process selected by the first window 11 is implemented.

For example, in Fig.3, "GATE OX" specifying gate oxidation is selected in the first window, while "ETCH OX all" and "OXID" are set as a process for implementing gate oxidation in the second window. Meanwhile, "ETCH OX all" specifies that the oxide film is removed in its entirety as the first process, while "OXID" specifies carrying out oxidation as a second process.

In the process set in the second window 12, the information on the conversion rule at the time of conversion of the manufacturing data into the simulator input data is edited using the editing screen shown in Fig.4, which illustrates a screen for editing the information concerning the conversion rule for the gate oxidation process step as an example of the editing screen. Using this editing screen, the information as to which is the keyword or which recipe is used or the other information required for converting the manufacturing data into simulator input data is entered. The recipe herein means the information previously registered in a database by the conversion database management module 4. In the example of Fig.4, the recipe is set so that the information previously registered under the designation of "OxPyrol.0" in the database will be used when converting the manufacturing data into the simulator input data.

Then, at step S1-2 of Fig.2, the information not stated in the manufacturing data but necessary in carrying out simulation, such as the information dependent on the semiconductor manufacturing device, is entered from the input device 7, such as keyboard, to the simulation device 7. At this time, the conversion database management module 4 controls the graphical user interface so that the user can easily enter the information not stated in the manufacturing data but necessary in carrying out simulation. The conversion database management module 4 also registers the information concerning gate oxidation in the database.

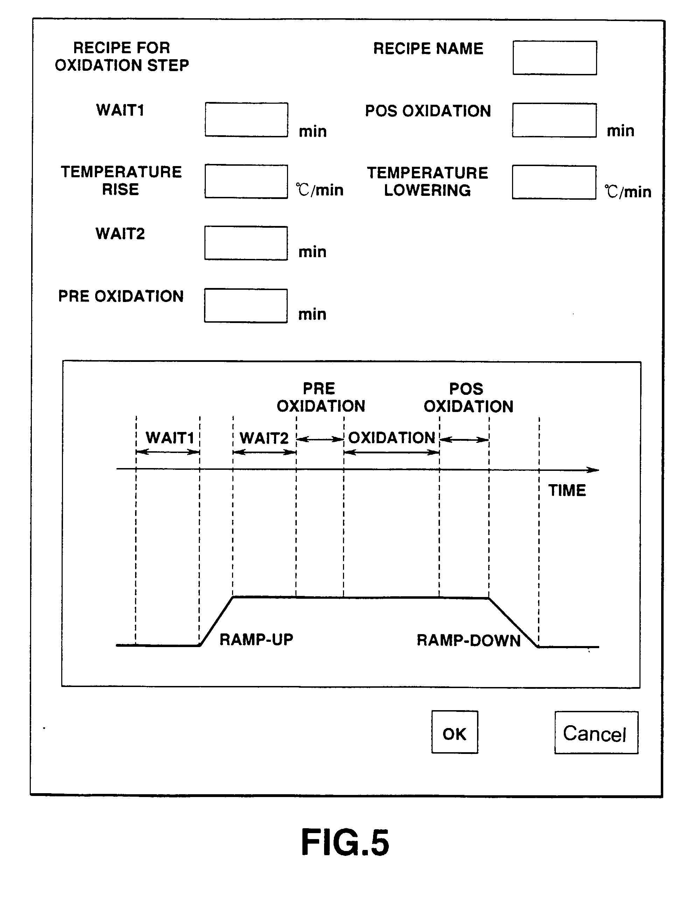

Fig.5 shows an example of a screen displayed on the display by the conversion database management module 4 when registering the information in a database. Fig.5 shows an example of a picture displayed by the conversion database management module 4 when entering data not contained in the manufacturing data but required for simulation in connection with gate oxidation. That is, when the information concerning gate oxidation is registered in the database, the information on the temperature rising rate or falling rate, the information on the queuing time since charging into a furnace until starting the oxidation processing or the information on the queuing time since the end of the oxidation processing until discharging from the furnace, is entered using the editing screen shown in Fig.5, while the designation by which these information items are registered in the database, is entered as recipe.

Meanwhile, the conversion rule set at step S1-1 or the information registered at step S1-2 is the basic information in converting the manufacturing data into the simulator input data and, if these information items are entered previously, there is no necessity of repeatedly entering these items each time data is converted. Therefore, if the supervisor of the simulation device 1 previously enters these information items and the users in general convert these information items into simulator input data, the user can select the previously set conversion rule or the information previously registered in the database. This enables the user with only poor knowledge about data conversion to easily convert the manufacturing data into the simulator input data.

Then, at step S1-3 of Fig. 2, semiconductor manufacturing data is entered to the simulation device 1 as basic data for carrying out simulation concerning semiconductor impurity distribution. At this time, the manufacturing data input module 2 reads manufacturing data from outside via a recording medium such as a flexible disc or via a computer network, or reads manufacturing data via an annexed recording medium, such as a hard disc or a flexible disc, or via a computer network.

Then, at step S1-4, the manufacturing data is converted into simulator input data. At this time, the automatic data conversion module 5 converts the manufacturing data read at step S1-3 into simulator input data in accordance with the conversion rule as set at step S1-1. The automatic data conversion module 5 refers to the information registered at step S1-2 in the database, if need be, for extracting the necessary information from the database for adding the extracted data to the simulator input data.

Then, at step S1-4, the manufacturing data is converted into simulator input data. At this time, the automatic data conversion module 5 converts the manufacturing data stating the recorded information concerning the semiconductor manufacturing conditions, by having reference to the information registered in the database at step S1-2, in accordance with the conversion rule as set at step S1-1. The conversion technique will be explained in detail subsequently.

It is desirable that plural conversion rules be provided for coping with different types or generations of the semiconductors. It is similarly desirable that the database of the information dependent on the manufacturing devices not stated in the manufacturing data furnishes data for a variety of manufacturing devices. As for the manufacturing data, the information is desirably stored by way of recording which item has been simulated or for checking the difference in case plural calculations conducted are based on different sorts of data. By providing plural sorts of the conversion rules or manufacturing data in this manner, there is no necessity to enter the conversion rules or manufacturing data each time conversion is made, such that the manufacturing data can be converted easily into simulator input data.

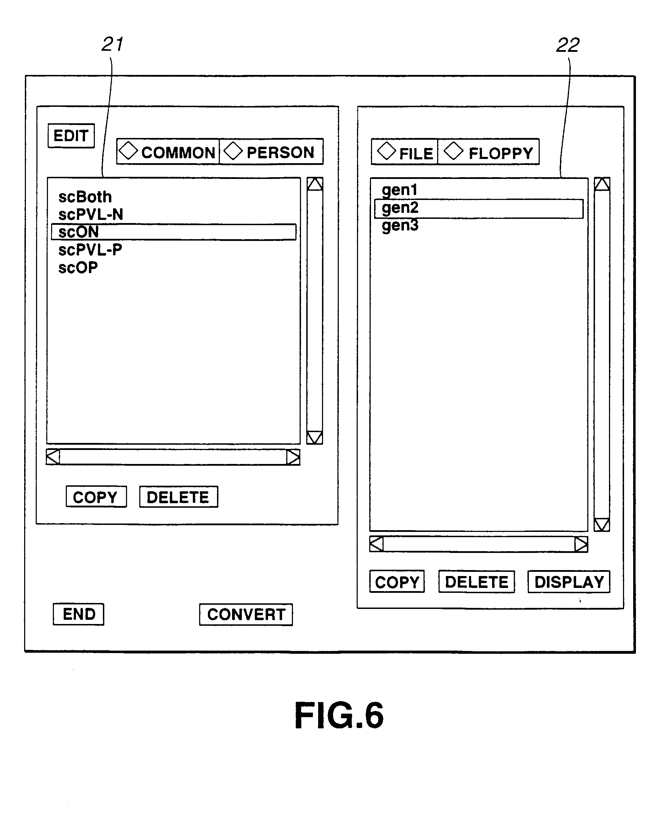

Fig.6 shows an example of a screen indicated on a display by the automatic data conversion module 5 when selecting the conversion rule or the manufacturing data from the plural sets of the conversion rules and manufacturing data. In Fig.6, the left window 21 and the right window 22 show the lists of the conversion rules and the manufacturing data, respectively. Fig.6 shows an example in which manufacturing data named "gen2" is converted into simulator input data based on the conversion rule registered under the name of "scON".

Then, at step S1-5 of Fig.2, the simulator input data is entered to the simulation calculating module 6. That is, at step S1-5, the automatic data conversion module 5 enters the simulator input data, prepared by converting the manufacturing data, to the simulation calculating module 6 operating as a simulator for simulating the semiconductor operating characteristics.

Then, at step S1-6, the simulation calculating module 6 carries out simulation of the semiconductor operating characteristics based on simulator input data entered from the automatic data conversion module 5. The semiconductor operating characteristics are calculated by solving physical equations concerning semiconductor physics, such as Poisson's equation (1):

$$V(\varepsilon \, \nabla_{\psi}) = q(n - p - C) \tag{1}$$

an electronic current continuity equation shown by the equation (2):

$$- \nabla \bullet J_n + qR = 0 \tag{2}$$

or the positive hole current continuity equation shown by the equation (3):

$$- \nabla \bullet J_p - qR = 0 \tag{3}$$

where $\varepsilon$, $\psi$, $q$, $n$, $p$, $C$, $J_n$, $J_p$ and $R$ denote the dielectric constant of a substrate formed of, for example, silicon, an electro-static potential, a unit charge, electron density, positive hole density, the difference between the n-type substrate impurity concentration and the p-type substrate impurity concentration, electronic current density, positive hole current density and the concentration of electrons or positive holes generated or annihilated per unit time, respectively.

By the above steps, simulation of the semiconductor operating characteristics is carried out based on the manufacturing data stating the recorded information concerning the semiconductor manufacturing conditions.

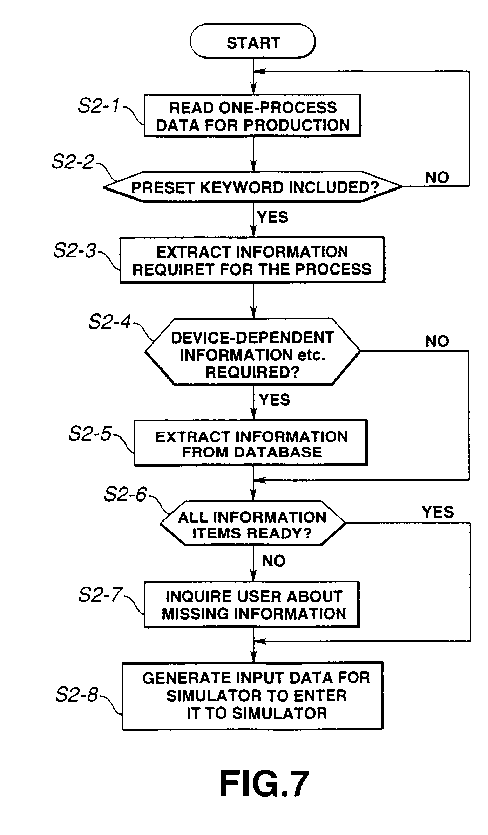

Next, the steps involved in converting the manufacturing data to the simulator input data, that is processing flow at the above step S1-3, is explained in detail by referring to the flowchart shown in Fig.7.

The flowchart of Fig.7 shows the flow of conversion of manufacturing data into simulator input data in terms of a sole process step of the manufacturing process, such as oxidation or etching. Thus, when simulator input data is formulated from manufacturing data, the processing shown in the flowchart of Fig.7 is carried out repeatedly a number of times equal to the number of the manufacturing process steps.

When converting manufacturing data into simulator input data, the automatic data conversion module 5 reads one process step data from the manufacturing data at step S2-1. Then, at step S2-2, the automatic data conversion module 5 checks whether a pre-set keyword is contained in the data read at step S2-1. If the pre-set data is contained in the read data, the automatic data conversion module 5 proceeds to the next step S2-3. If the pre-set data is not contained in the read data, the automatic data conversion module 5 reverts to step S2-1 to read in data of the next process step.

That is, at steps S2-1 and S2-2, the automatic data conversion module 5 sequentially reads out the manufacturing data to select the portion thereof containing the pre-set keyword and which states the necessary information. The pre-set keyword is set at step S1-1 as the conversion rule based on the empirical knowledge that terms such as "OX" or "oxidation" necessarily appear in the manufacturing data if the process step is the oxidation step.

Then, at step S2-3, the automatic data conversion module 5 extracts the information required to carry out the simulation from the data containing the pre-set keyword. The extracted information includes the information concerning the initial temperature, temperature at the time of oxidation, ultimate temperature, atmosphere, oxidation time or film thickness.

Then, at step S2-4, the automatic data conversion module 5 judges whether or not the information not stated in the manufacturing data but which is necessary for simulation, for example, the information dependent on the semiconductor manufacturing device, is required. If such information is required, the automatic data conversion module 5 proceeds to step S2-5 and, if otherwise, the automatic data conversion module 5 proceeds to step S2-6.

At step S2-5, the automatic data conversion module 5 has reference to the database in order to extract from the information registered in the database the information not stated in the manufacturing data but which is necessary for simulation.

If the process in question is the oxidation process, the extracted information is the information concerning temperature changes per unit time, that is the information concerning the temperature rising rate or falling rate, the information concerning the queuing time since charging into a furnace until start of oxidation processing, or the information concerning the queuing time since the end of oxidation processing until discharging from the furnace.

If sufficient information is contained in the manufacturing data, the simulator input data can be formulated from the information extracted from the above process steps. However, in the trial manufacturing stage of a semiconductor, sufficient information is not necessarily contained in the manufacturing data. For example, information concerning a special process step may occasionally be instructed as a separate sheet. In such case, sufficient information cannot be obtained to formulate the simulator input data.

Thus, at step S2-6, the automatic data conversion module 5 checks whether or not the information necessary for formulating the simulator input data has been laid in store. If the necessary information has not been laid in store, the automatic data conversion module 5 proceeds to step S2-7 and, if the necessary information has been laid in store in its entirety, the automatic data conversion module 5 proceeds to step S2-8.

At step S2-7, the automatic data conversion module 5 indicates on a display that information necessary for formulating the simulator input data is lacking and queries the user for the missing information. When the missing information has all been entered, the automatic data conversion module 5 proceeds to step S2-8.

At step S2-8, the automatic data conversion module 5 formulates the simulator input data from the information obtained from the above process step, and enters the formulated simulator input data to the simulation calculating module 6.

The above processing completes conversion from manufacturing data to the simulator input data for a given process step. This processing is carried out for each process step, as a result of which simulator input data corresponding to the entire set of process steps is entered to the simulation calculating module 6.

By converting the manufacturing data to simulator input data as described above, it becomes possible to use manufacturing data for simulation, as a result of which it becomes possible to carry out simulation of the semiconductor operating characteristics very easily.

As illustrative examples of the above-described data conversion, Tables 1 and 2 below illustrate an example of the manufacturing data and the simulator input data formulated by conversion of the manufacturing data shown in Table 1, respectively.

## TABLE 1

GATE OX   A001001   IN/OUT 750°C   900/900°   1.0P   50'   20nm ± 2 nm

## TABLE 2

DIFF   TEMP = 750   TEMPE = 900   TIME = 30

OXID   THICK = 0.2   PRESS = 1   TIME = 50   TEMP = 900

DIFF   TEMP = 900   TEMPE = 750   TIME = 66

In the manufacturing data shown in Table1, "GATE OX" and "A001001" specify the process name and the device name, respectively. On the other hand, "IN/OUT 750°", "900/900°", "1.OP", "50'", "20 nm" and "±2 nm" specify the temperature at the time of entrance/exit to the furnace being 750°C, the temperature in the furnace at the time of oxidation being 900°C, the atmospheric pressure in the furnace being 1 atm, the oxidation time being 50 minutes, the film thickness being 20 nm and an error of film thickness being ± 2 nm, respectively.

Of the above information items, the device name or the film thickness error is not required for simulation. In the above information items, part of the information required for simulation, such as the information concerning the temperature rising rate or the temperature falling rate, the information regarding time which elapses since charging into the furnace until discharging from the furnace on completion of the oxidation processing, is not included.

Thus, when converting the manufacturing data to the simulator input data, data other than the device name and the film thickness error are extracted from the manufacturing data. In addition, reference is had to the database to add the information concerning the temperature rising rate or the temperature falling rate, the information regarding time which elapses and, if necessary, changes which occur between charging into the furnace until discharging from the furnace on completion of the oxidation processing, to formulate the simulator input data shown in Table 2.

In the simulator input data, thus prepared, shown in Table 2, the first line beginning from 'DIFF' is data taking into account the diffusion which occurs since charging into the furnace until start of the oxidation processing. In this line, DIFF TEMP = 750, TEMPE = 900 and TIME = 30 specify the temperature at the time of charging into the furnace being 750°C, the temperature at the end of this queuing time being 900°C and the queuing time being 30 minutes, respectively.

The second line beginning from "OXID" data specify the conditions for oxidation. In this line, THICK = 0.2, PRESS = 1, TIME = 50 and TEMP = 900 specify the film thickness being 20 nm, the atmospheric pressure in the furnace being 1 atm, the oxidation time being 50 minutes and the temperature at the time of oxidation being 900°C, respectively.

The third row beginning from "DIFF" is data taking into account the diffusion which takes place during the queuing time from the end of the oxidation processing until discharging from the furnace. In this line, TEMP = 900, TEMPE = 750 and TIME = 66 specify that the temperature at the end of the oxidation processing being 900°C, the temperature at the end of this queuing time being 750°C and the duration of this queuing time being 66 minutes, respectively.

## Claims

1. A semiconductor simulation method comprising:

   a converting step of converting manufacturing data stating recorded information concerning the manufacturing conditions for manufacturing a semiconductor into simulator input data necessary for simulation of distribution of impurities in the semiconductor; and
   a simulating step of entering said simulator input data to a simulator simulating the operating characteristics of the semiconductor for carrying out simulation of impurities and electric characteristics of the semiconductor based on the simulator input data.

2. The semiconductor simulation method as claimed in claim 1, further comprising:
   a conversion rule setting step of setting, prior to the conversion step, a conversion rule applicable at the time of converting the manufacturing data into the simulator input data.

3. The semiconductor simulation method as claimed in claim 1, further comprising:

   previously registering in a database the information necessary for converting the manufacturing data into simulator input data; and
   extracting from the database in said conversion step the information necessary for conversion.

4. A semiconductor simulation method comprising the steps of:

   entering information concerning a conversion rule applicable in converting manufacturing data into simulator input data;
   entering information which depends on a manufacturing device;
   reading in said manufacturing data;
   converting said manufacturing data into the simulator input data;
   entering the simulator input data into a simulation calculating module; and
   carrying out simulation based on said simulator input data.

5. The semiconductor simulation method as claimed in claim 4, wherein said conversion rules are displayed at least by two screens and the process step for semiconductor manufacture is displayed in one of said screens.

**6.** The semiconductor simulation method as claimed in claim 5, wherein a process step is selected from a plurality of displayed process steps.

**7.** The semiconductor simulation method as claimed in claim 5, wherein the process step sort is displayed and selected on the other of the two screens.

**8.** The semiconductor simulation method as claimed in claim 4, wherein, as the manufacturing device dependent information, data concerning the temperature, time and pressure is entered.

**9.** The semiconductor simulation method as claimed in claim 4, wherein said manufacturing data is read via a recording medium or a computer network.

**10.** The semiconductor simulation method as claimed in claim 4, wherein, at the process step of converting the manufacturing data into simulator input data, said manufacturing data is converted based on the conversion rule with reference to the information registered in a data-base

**11.** The semiconductor simulation method as claimed in claim 10, wherein plural data associated with characteristics desired to be investigated and the sorts or generations of the semiconductor are used as said conversion rule.

**12.** The semiconductor simulation method as claimed in claim 11, wherein at least two conversion rules are displayed on a screen, with a list of the conversion rules being displayed on one screen portion and a list of manufacturing data being displayed on the other screen portion.

**13.** A semiconductor simulation method comprising:

a converting step of converting manufacturing data stating recorded information concerning the manufacturing conditions for manufacturing a semiconductor into simulator input data necessary for simulation of operating characteristics of the semiconductor based on a database for conversion; and
a simulating step of entering said simulator input data to a simulator simulating the operating characteristics of the semiconductor for carrying out simulation of electric characteristics of the semiconductor based on the simulator input data.

**14.** The semiconductor simulation method as claimed in claim 13, further comprising:
a conversion rule setting step of setting, prior to the conversion step, a conversion rule applicable at the time of converting the manufacturing data into the simulator input data.

**15.** The semiconductor simulation method as claimed in claim 13, further comprising:

previously registering in a data-base the information necessary for converting the manufacturing data into simulator input data; and
extracting from the data-base in said conversion step the information necessary for conversion.

**16.** The semiconductor simulation method as claimed in claim 13, wherein an automatic data conversion module having said data-base for conversion sequentially selects manufacturing data in order to locate the information containing a pre-set keyword.

**17.** The semiconductor simulation method as claimed in claim 13, wherein an automatic data conversion module having said data-base for conversion judges whether the information necessary for formulating the simulator input data has been laid in store.

**FIG.1**

ENTER CONVERSION RULE — S1-1

ENTER DEVICE-DEPENDENT INFORMATION — S1-2

READ DATA FOR PRODUCTION — S1-3

CONVERT DATA FOR PRODUCTION INTO INPUT DATA FOR SIMULATOR — S1-4

ENTER INPUT DATA FOR SIMULATOR TO SIMULATION COMPUTING MODULE — S1-5

SIMULATE BASED ON INPUT DATA FOR SIMULATION — S1-6

# FIG.2

*11*

SAVE   END

LIST OF SCENES

INIT
1 OX
PAD OX
POLY CVD
PPL POLY OX
PPL SIN CVD
LOCOS OX
PPL SIN REMOVE
PPL POLY SI RIE
SACRIFICE OX
NCH II
GATE OX
1 POLY CVD
PHOS PREDEPO
NCH LDD II

NEXT

PREV

ADD

EDIT

DELETE

UNDO

LIST OF PROCESSES

ETCH OX all
OXID

ADD

EDIT

DELETE

UNDO

*12*

FIG.3

OXIDATION

| OUTPUT FORM | OXIDATION STEP | ◇Diff+Depo | ◇DIFFUSION STEP |
|---|---|---|---|

| ULTIMATE FILM THICKNESS | | INITIAL FILM THICKNESS | |
|---|---|---|---|

| RECIPE | OxPyro1.0 |
|---|---|

| KEYWORD | GATE OX | OX |
|---|---|---|

| SPIF OUTPIT | ◇YES | ◇NO |
|---|---|---|

| OK | Cancel |
|---|---|

# FIG.4

RECIPE FOR
OXIDATION STEP

RECIPE NAME [ ]

WAIT1 [ ] min

POS OXIDATION [ ] min

TEMPERATURE
RISE [ ] ℃/min

TEMPERATURE
LOWERING [ ] ℃/min

WAIT2 [ ] min

PRE OXIDATION [ ] min

PRE
OXIDATION

POS
OXIDATION

WAIT1 ← WAIT2 ← → OXIDATION ←

TIME

RAMP-UP

RAMP-DOWN

[ OK ] [ Cancel ]

## FIG.5

*21*                *22*

EDIT    ◇ COMMON ◇ PERSON      ◇ FILE ◇ FLOPPY

**scBoth**
**scPVL-N**
**scON**
**scPVL-P**
**scOP**

**gen1**
**gen2**
**gen3**

COPY   DELETE

COPY   DELETE   DISPLAY

END       CONVERT

# FIG.6

15

FIG.7